# EUROPEAN PATENT SPECIFICATION

(11) **EP 3 866 210 B1**
(45) Date of publication and mention of the grant of the patent: **08.05.2024**
(21) Application number: 19870259.9
(22) Date of filing: 30.07.2019
(51) Int. Cl.: H01L 31/18, H01L 31/0216

(54) **METHOD FOR REMOVING EXCESS FILM FROM FRONT SURFACE OF CRYSTALLINE SILICON SOLAR CELL**
VERFAHREN ZUR ENTFERNUNG ÜBERSCHÜSSIGEN FILMES VON DER FRONTFLÄCHE EINER KRISTALLINEN SILIZIUMSOLARZELLE
PROCÉDÉ D'ÉLIMINATION DU REVÊTEMENT DE FACE AVANT D'UNE CELLULE SOLAIRE EN SILICIUM CRISTALLIN

(30) Priority: 12.10.2018 CN 201811188840
(43) Date of publication of application: 18.08.2021
(73) Proprietor: Zhejiang Aiko Solar Energy Technology Co., Ltd., Yiwu, Zhejiang 322009 (CN)
(72) Inventor: WU, Huimin, Yiwu, Zhejiang 322009 (CN); ZHANG, Xiaoming, Yiwu, Zhejiang 322009 (CN); FANG, Jiebin, Yiwu, Zhejiang 322009 (CN); LIN, Kang-Cheng, Yiwu, Zhejiang 322009 (CN); HE, Daneng, Yiwu, Zhejiang 322009 (CN); CHEN, Gang, Yiwu, Zhejiang 322009 (CN)
(74) Representative: Ipside
(86) International application number: PCT/CN2019/098403
(87) International publication number: WO 2020/073720

(56) References cited:
- CN-A- 107 256 898
- CN-B- 105 470 348
- CN-B- 105 845 781

## Description

### Technical Field

The present invention pertains to a technology for preparing a crystalline silicon solar cell, and in particular, relates to a method for removing an excess film from a front face of a crystalline silicon solar cell.

### Background of the Invention

For crystalline silicon cells, the passivated emitter rear cell (PERC) backside passivation technology has effectively alleviated the problem of contact recombination between crystalline silicon and metal on a back face, and greatly improved the photoelectric conversion efficiency of crystalline silicon cells. A tubular plasma film deposition machine used for the preparation of PERC crystalline silicon cells has been widely used because of its integrated preparation, mature process, and low costs.

In the back-face film deposition process, a silicon wafer is carried by a graphite boat and placed in the tubular plasma film deposition machine. A stuck point on the graphite boat jams the silicon wafer, and the graphite boat is in contact with a front face of the silicon wafer. Because a textured surface on the front face of the silicon wafer should not be damaged, the stuck point on the graphite boat cannot firmly jam the silicon wafer. Consequently, a backside passivation film occurs on an edge of the front face of the silicon wafer after the back-face film deposition, and an excess film occurs on the front face of a prepared finished cell. This not only greatly affects the appearance of the cell, but also reduces the photoelectric conversion efficiency of the cell.

Patent document CN 107 256 898 A discloses a bifacial PERC solar cell.

Patent document CN 105 845 781 B describes a method for eliminating a belt mark on a PERC solar cell.

Patent document CN 105 470 348 B discloses a method for removing an unwanted rear coating.

### Summary of the Invention

An objective of the present invention is to provide a method for alleviating a problem of an excess film from a front face of a crystalline silicon solar cell, so as to improve the appearance of the cell and the photoelectric conversion efficiency of the cell.

The objective of the present invention is achieved using the following technical solution: A method for removing an excess film from a front face of a crystalline silicon solar cell includes the following steps:
S1: Depositing an Al₂O₃ film, an SiO₂ film, and an SiNₓ film on a back face of a silicon wafer to form a backside passivation film, and forming an excess film on an edge of the front face of the silicon wafer;
S2: Preparing an aqueous film on a surface of the backside passivation film of the product obtained in step S1;
S3: Enabling the product obtained in step S2 to pass through an acid tank to remove the excess film;
S4: Enabling the product obtained in step S3 to pass through a water tank to remove a residual treatment solution; and
S5: Drying the product obtained in step S4.

According to the present invention, removing an excess passivation film that is formed on an edge of the front face of the silicon wafer deposited with a backside passivation film alleviates the problem of an excess film on a front face of a tubular crystalline silicon solar PERC. In addition, the backside passivation film of Al₂O₃/SiO₂/SiNₓ differs from the backside passivation film of Al₂O₃/SiNₓ of the existing cell in that an SiO₂ film is added between the conventional backside passivation films Al₂O₃/SiNₓ, thereby improving the hydrophilicity of the aqueous film, and helping remove the excess film from the front face of the silicon wafer and prevent the backside passivation film from being corroded by a gas phase. According to the present invention, the excess film on the front face of the silicon wafer is removed, that is, metal ions on the front face of the silicon wafer are removed, thereby avoiding recombination caused by metal ions. Therefore, both the appearance of a cell and the photoelectric conversion efficiency of the cell are greatly improved.

In some embodiments, the acid tank is an HF/HCl tank.

In some embodiments, after step S4 is completed, the product obtained in step S4 is passed through a hydrochloric acid tank to remove excess metal ions, and then passed through a water tank to remove a residual treatment solution; then step S5 is performed. Removing excess metal ions on the silicon wafer can further improve the photoelectric conversion efficiency of the cell.

In some embodiments, a thickness of the SiO₂ film is 2-10 nm, which improves the passivation effect and makes it possible to form a good aqueous film in a next step.

In some embodiments, in an HF/HCl solution, a volume ratio of HF is 40% to 60%, and a volume ratio of HCl is 5% to 20%.

In some embodiments, in a hydrochloric acid solution, a volume ratio of HCl is 30%.

In some embodiments, the crystalline silicon solar cell is a PERC-type cell.

In some embodiments, step S1 is performed in the tubular plasma film deposition machine.

In some embodiments, according to the present invention, preparation is totally completed on a chain cleaning machine. A belt speed of the chain cleaning machine is related to a tank. In steps S2 to S5, time taken for the silicon wafer to pass through corresponding work stations is 1-2 minutes.

Compared with the prior art, the present invention has the following remarkable effects:
(1) According to the present invention, removing an excess passivation film that is formed on an edge of the front face of the silicon wafer deposited with a backside passivation film alleviates the problem of an excess film on a front face of a tubular crystalline silicon solar PERC. According to the present invention, the excess film on the front face of the silicon wafer is removed, that is, metal ions on the front face of the silicon wafer are removed, thereby avoiding recombination caused by metal ions. Therefore, both the appearance of a cell and the photoelectric conversion efficiency of the cell are greatly improved.
(2) The backside passivation film of Al₂O₃/SiO₂/SiNₓ according to the present invention differs from the backside passivation film of Al₂O₃/SiNₓ of the existing cell in that an SiO₂ film is added between the conventional backside passivation films Al₂O₃/SiNₓ, thereby improving the hydrophilicity of the aqueous film, and helping remove the excess film from the front face of the silicon wafer and prevent the backside passivation film from being corroded by a gas phase.
(3) Optionally, according to the present invention, after the excess film is removed from the silicon wafer, the silicon wafer is passed through a hydrochloric acid tank to remove excess metal ions, thereby further improving the photoelectric conversion efficiency of the cell.

### Brief description of the Drawings

The following gives a more detailed description of the present invention with reference to the accompanying drawings.

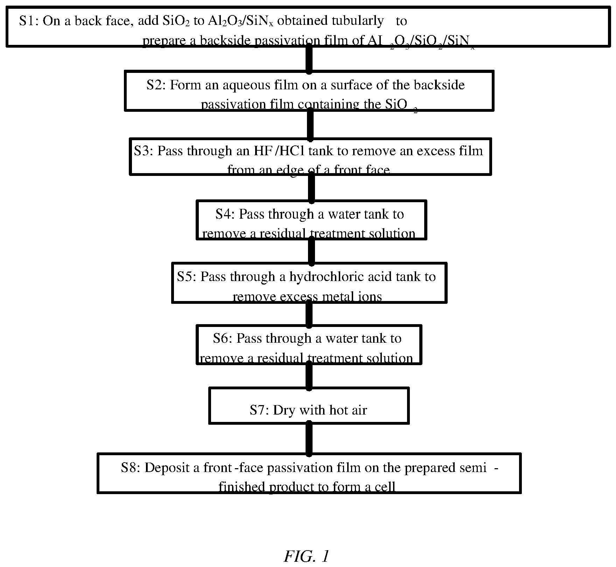

FIG. 1 is a block diagram of a process according to Embodiment 1 of the present invention.

### Detailed Description of Embodiments

### Embodiment 1

FIG. 1 shows a method for alleviating a problem of an excess film on a front face of a crystalline silicon solar PERC cell coated in a tubular plasma film deposition machine. The method is totally completed on a chain cleaning machine, and specifically includes the following steps:
S1: In a process of depositing a backside passivation film on a silicon wafer, sequentially depositing an Al₂O₃ film, an SiO₂ film, and an SiNₓ film on a back face of the silicon wafer in a tubular plasma film deposition machine to form a backside passivation film, where because a stuck point on a graphite boat does not firmly jam the silicon wafer, an excess film is formed on an edge of a front face of the silicon wafer; to form a good aqueous film in a next step and improve a passivation effect, a thickness of the SiO₂ film is preferably 2-10 nm;
S2: Preparing an aqueous film on a surface of the backside passivation film of the product obtained in step S1, where the aqueous film covers the entire backside passivation film; the aqueous film is prepared in such a way that water is dripped on the surface of the backside passivation film, and the water does not fall when the machine vibrates; additionally arranging the SiO₂ film between the conventional backside passivation films Al₂O₃/SiNₓ improves the hydrophilicity of the aqueous film, and helps remove the excess film from the front face of the silicon wafer and prevent the backside passivation film from being corroded by a gas phase in a subsequent process;
S3: Enabling the product obtained in step S2 to pass through an HF/HCl tank to remove the excess film, where in an HF/HCl solution, a volume ratio of HF is 55%, and a volume ratio of HCl is 10%; by way of example, time taken for the product to pass through the HF/HCl tank is 1.5 minutes;
S4: Enabling the product obtained in step S3 to pass through a water tank to remove a residual HF/HCl solution; optionally, enabling the product to pass through a hydrochloric acid tank to remove excess metal ions, where in a hydrochloric acid solution, a volume ratio of HCl is 30%; by way of example, time taken for the product to pass through the hydrochloric acid tank is 1 minute; and then enabling the product to pass through a water tank to remove a residual hydrochloric acid solution, and then going to step S5; and
S5: Drying the product obtained in step S4 with hot air. Then, a front-face passivation film is deposited on the prepared semi-finished product to form a cell.

### Embodiment 2

This embodiment differs from Embodiment 1 in that in step S3, in an HF/HCl solution, a volume ratio of HF is 40%, a volume ratio of HCl is 5%, and time taken for a product to pass through an HF/HCl tank is 2 minutes. In step S4, time taken for the product to pass through a hydrochloric acid tank is 2 minutes.

### Embodiment 3

This embodiment differs from Embodiment 1 in that in step S3, in an HF/HCl solution, a volume ratio of HF is 60%, a volume ratio of HCl is 20%, and time taken for a product to pass through an HF/HCl tank is 1 minutes. In step S4, time taken for the product to pass through a hydrochloric acid tank is 1 minute.

A belt speed of a chain cleaning machine is related to a tank. In some embodiments, in steps S2 to S5, time taken for a silicon wafer to pass through corresponding work stations is preferably 1-2 minutes. In some embodiments, in an HF/HCl solution, a volume ratio of HF is 40% to 60%, and a volume ratio of HCl is 5% to 20%.

The embodiments of the present invention are not limited to the foregoing description. Based on the foregoing description of the present invention, various other forms of modifications, replacements, or changes falling within the scope of the appended claims may be further made to the present invention by using common technical knowledge and conventional methods in the field without departing from the foregoing basic technical ideas of the present invention.

## Claims

1. A method for removing an excess film from a front face of a crystalline silicon solar cell, comprising the following steps:
S1: depositing an Al₂O₃ film, an SiO₂ film, and an SiNₓ film on a back face of a silicon wafer to form a backside passivation film, and forming an excess film on an edge of a front face of the silicon wafer;
S2: preparing an aqueous film on a surface of the backside passivation film of the product obtained ir
step S1 which is the silicon wafer with the backside passivation film and the excess film;
S3: enabling the product obtained in step S2 to pass through an acid tank to remove the excess film;
S4: enabling the product obtained in step S3 to pass through a water tank to remove a residual treatment solution; and
S5: drying the product obtained in step S4.

2. The method for removing an excess film from a front face of a crystalline silicon solar cell according to claim 1, further comprising: after step S4 is completed, enabling the product obtained in step S4 to pass through a hydrochloric acid tank to remove excess metal ions, and then pass through a water tank to remove a residual treatment solution; and then going to step S5.

3. The method for removing an excess film from a front face of a crystalline silicon solar cell according to claim 1 or 2, wherein a thickness of the SiO₂ film is 2-10 nm.

4. The method for removing an excess film from a front face of a crystalline silicon solar cell according to claim 1, wherein the acid tank is an HF/HCl tank.

5. The method for removing an excess film from a front face of a crystalline silicon solar cell according to claim 4, wherein in an HF/HCl solution, a volume ratio of HF is 40% to 60%, and a volume ratio of HCl is 5% to 20%.

6. The method for removing an excess film from a front face of a crystalline silicon solar cell according to claim 2, wherein in a hydrochloric acid solution, a volume ratio of HCl is 30%.

7. The method for removing an excess film from a front face of a crystalline silicon solar cell according to claim 1, wherein in steps S2 to S5, time taken for the silicon wafer to pass through corresponding work stations is 1-2 minutes.

8. The method for removing an excess film from a front face of a crystalline silicon solar cell according to claim 1, wherein the crystalline silicon solar cell is a PERC-type cell.

9. The method for removing an excess film from a front face of a crystalline silicon solar cell according to claim 1, wherein step S1 is performed in a tubular plasma film deposition machine.

10. The method for removing an excess film from a front face of a crystalline silicon solar cell according to claim 1, wherein steps S2 to S5 are performed by a chain cleaning machine.

## Patentansprüche

1. Verfahren zum Entfernen eines überschüssigen Films von einer Vorderseite einer kristallinen Silizium-Solarzelle, das die folgenden Schritte umfasst:
S1: Abscheiden eines Al₂O₃-Films, eines SiO₂-Films und eines SiNₓ-Films auf einer Rückseite eines Siliziumwafers, um einen Rückseitenpassivierungsfilm zu bilden, und Bilden eines überschüssigen Films an einer Kante einer Vorderseite des Siliziumwafers;
S2: Herstellen eines wässrigen Films auf einer Oberfläche des Rückseitenpassivierungsfilms des in Schritt S1 erhaltenen Produkts, bei dem es sich um den Siliziumwafer mit dem Rückseitenpassivierungsfilm und dem überschüssigen Film handelt;
S3: Laufenlassen des in Schritt S2 erhaltenen Produkts durch einen Säuretank, um den überschüssigen Film zu entfernen;
S4: Laufenlassen des in Schritt S3 erhaltenen Produkts durch einen Wassertank, um eine restliche Behandlungslösung zu entfernen; und
S5: Trocknen des in Schritt S4 erhaltenen Produkts.

2. Verfahren zum Entfernen eines überschüssigen Films von einer Vorderseite einer kristallinen Silizium-Solarzelle nach Anspruch 1, weiter umfassend: nachdem Schritt S4 abgeschlossen ist, Laufenlassen des in Schritt S4 erhaltenen Produkts durch einen Salzsäuretank, um überschüssige Metallionen zu entfernen, und dann Leiten durch einen Wassertank, um eine restliche Behandlungslösung zu entfernen; und dann Weitergehen zu Schritt S5.

3. Verfahren zum Entfernen eines überschüssigen Films von einer Vorderseite einer kristallinen Silizium-Solarzelle nach Anspruch 1 oder 2, wobei eine Dicke des SiO₂-Films 2-10 nm beträgt.

4. Verfahren zum Entfernen eines überschüssigen Films von einer Vorderseite einer kristallinen Silizium-Solarzelle nach Anspruch 1, wobei der Säuretank ein HF/HCl-Tank ist.

5. Verfahren zum Entfernen eines überschüssigen Films von einer Vorderseite einer kristallinen Silizium-Solarzelle nach Anspruch 4, wobei in einer HF/HCl-Lösung ein Volumenverhältnis von HF 40 % bis 60 % beträgt, und ein Volumenverhältnis von HCl 5 % bis 20 % beträgt.

6. Verfahren zum Entfernen eines überschüssigen Films von einer Vorderseite einer kristallinen Silizium-Solarzelle nach Anspruch 2, wobei in einer Salzsäurelösung ein Volumenverhältnis von HCl 30 % beträgt.

7. Verfahren zum Entfernen eines überschüssigen Films von einer Vorderseite einer kristallinen Silizium-Solarzelle nach Anspruch 1, wobei in den Schritten S2 bis S5 die Zeit, die der Siliziumwafer benötigt, um durch entsprechende Arbeitsstationen zu laufen, 1-2 Minuten beträgt.

8. Verfahren zum Entfernen eines überschüssigen Films von einer Vorderseite einer kristallinen Silizium-Solarzelle nach Anspruch 1, wobei die kristalline Silizium-Solarzelle eine Zelle vom Typ PERC ist.

9. Verfahren zum Entfernen eines überschüssigen Films von einer Vorderseite einer kristallinen Silizium-Solarzelle nach Anspruch 1, wobei Schritt S1 in einer röhrenförmigen Plasmafilmabscheidemaschine durchgeführt wird.

10. Verfahren zum Entfernen eines überschüssigen Films von einer Vorderseite einer kristallinen Silizium-Solarzelle nach Anspruch 1, wobei die Schritte S2 bis S5 von einer Kettenreinigungsmaschine durchgeführt werden.

## Revendications

1. Procédé d'élimination d'un film excédentaire d'une face avant d'une cellule solaire en silicium cristallin, comprenant les étapes suivantes :
S1 : le dépôt d'un film d'Al₂O₃, d'un film de SiO₂, et d'un film de SiNₓ sur une face arrière d'une tranche de silicium pour former un film de passivation de côté arrière, et la formation d'un film excédentaire sur un bord d'une face avant de la tranche de silicium ;
S2 : la préparation d'un film aqueux sur une surface du film de passivation de côté arrière du produit obtenu dans l'étape S1 qui est la tranche de silicium avec le film de passivation de côté arrière et le film excédentaire ;
S3 : l'autorisation du produit obtenu dans l'étape S2 de traverser un réservoir d'acide pour éliminer le film excédentaire ;
S4 : l'autorisation du produit obtenu dans l'étape S3 de traverser un réservoir d'eau pour éliminer une solution de traitement résiduelle ; et
S5 : le séchage du produit obtenu dans l'étape S4.

2. Procédé d'élimination d'un film excédentaire d'une face avant d'une cellule solaire en silicium cristallin selon la revendication 1, comprenant en outre : une fois que l'étape S4 est terminée, l'autorisation du produit obtenu dans l'étape S4 de traverser un réservoir d'acide chlorhydrique pour éliminer des ions métalliques excédentaires, puis de traverser un réservoir d'eau pour éliminer une solution de traitement résiduelle ; puis le passage à l'étape S5.

3. Procédé d'élimination d'un film excédentaire d'une face avant d'une cellule solaire en silicium cristallin selon la revendication 1 ou 2, dans lequel une épaisseur du film de SiO₂ est de 2-10 nm.

4. Procédé d'élimination d'un film excédentaire d'une face avant d'une cellule solaire en silicium cristallin selon la revendication 1, dans lequel le réservoir d'acide est un réservoir d'HF/HCI.

5. Procédé d'élimination d'un film excédentaire d'une face avant d'une cellule solaire en silicium cristallin selon la revendication 4, dans lequel dans une solution d'HF/HCI, un rapport volumique d'HF est de 40 % à 60 %, et un rapport volumique d'HCI est de 5 % à 20 %.

6. Procédé d'élimination d'un film excédentaire d'une face avant d'une cellule solaire en silicium cristallin selon la revendication 2, dans lequel dans une solution d'acide chlorhydrique, un rapport volumique d'HCI est de 30 %.

7. Procédé d'élimination d'un film excédentaire d'une face avant d'une cellule solaire en silicium cristallin selon la revendication 1, dans lequel dans les étapes S2 à S5, le temps nécessaire pour que la tranche de silicium traverse des stations de travail correspondantes est de 1-2 minutes.

8. Procédé d'élimination d'un film excédentaire d'une face avant d'une cellule solaire en silicium cristallin selon la revendication 1, dans lequel la cellule solaire en silicium cristallin est une cellule de type PERC.

9. Procédé d'élimination d'un film excédentaire d'une face avant d'une cellule solaire en silicium cristallin selon la revendication 1, dans lequel l'étape S1 est réalisée dans une machine de dépôt de film plasma tubulaire.

10. Procédé d'élimination d'un film excédentaire d'une face avant d'une cellule solaire en silicium cristallin selon la revendication 1, dans lequel les étapes S2 à S5 sont réalisées par une machine de nettoyage de chaîne.
